Europäisches Patentamt

European Patent Office

Office européen des brevets

(11) Publication number: **0 327 138 B1**

# EUROPEAN PATENT SPECIFICATION

(45) Date of publication of patent specification: **02.06.93**   (51) Int. Cl.5: **H01P 1/26**

(21) Application number: **89103821.8**

(22) Date of filing: **01.12.84**

(60) Publication number of the earlier application in accordance with Art.76 EPC: **0 150 336**

(54) **Wide bandwidth R.F. load.**

(30) Priority: **09.01.84 US 568986**

(43) Date of publication of application:
**09.08.89 Bulletin 89/32**

(45) Publication of the grant of the patent:
**02.06.93 Bulletin 93/22**

(84) Designated Contracting States:
**DE FR GB**

(56) References cited:
**DE-B- 1 154 535       DE-C- 1 144 354**
**US-A- 2 579 751       US-A- 2 779 002**
**US-A- 3 278 840       US-A- 3 309 634**
**US-A- 3 479 587       US-A- 3 483 419**
**US-A- 3 560 889**

**PATENT ABSTRACTS OF JAPAN, vol. 7, no. 88 (E-170)[1233], 12th April 1983; & JP-A-58 15 310**

**ELECTRONICS AND COMMUNICATIONS IN JAPAN, vol. 53, no. 7, July 1970, pages 65-71; Y. SHIMIZU et al.: "Absorbing wall utilizing the combination of lossy dielectric layers and a magnetic layer"**

**ELECTRONICS AND COMMUNICATIONS IN JAPAN, vol. 58-B, no. 5, May 1975, pages 52-59; Y. KOTSUKA et al.: "Design of a small-sized coaxial attenuator using a ferrite cylinder"**

(73) Proprietor: **Hewlett-Packard Company**
**Mail Stop 20 B-O, 3000 Hanover Street**
**Palo Alto, California 94304(US)**

(72) Inventor: **Donecker, S. Bruce**
**4920 Burnside Road**
**Sebastopol California 95472(US)**
Inventor: **Botka, Julius K.**
**5120 Carriage Lane**
**Santa Rosa California 95401(US)**

(74) Representative: **KOHLER SCHMID + PARTNER**
**Patentanwälte**
**Ruppmannstrasse 27**
**W-7000 Stuttgart 80 (DE)**

## Description

The present invention relates to a wide bandwidth R.F. load.

Wide bandwidth R.F. loads or precision terminations are used for several high frequency applications, and are, for example, required as terminations of vector network analyzers.

For this field of application, precision terminations are required having an essentially contant impedance over a very wide range of frequencies, the return loss being 40 dB or less from 1 GHz to 26.5 GHz and less than 34 dB from 45 MHz to 16 Hz.

Thus, the present invention has as its object of providing a precision termination or wide bandwidth R.F. load which can be used over a broader frequency range at and essentially constant impedance than has previously been possible.

This object is achieved by a wide bandwidth R.F. load in accordance with the prior art portion of claim 1 having the features indicated in the characterizing portion thereof.

An embodiment of the invention will now be discussed in detail with reference to the accompanying drawings. In the drawings,

Fig. 1 shows a reference load according to the invention;

Fig. 2A, 2B, 2C, 2D, 2E and 2G show expanded views of the reference load and its elements; and

Fig. 2F shows a graph of electrical characteristics of beads shown in Fig. 2C.

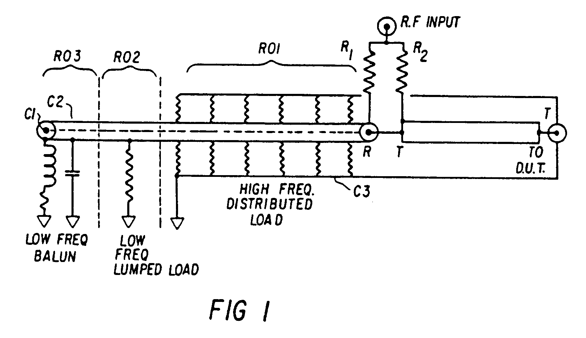

A wide bandwith R.F. load is a precision element with a flat response over the entire frequency range of interest, which in the preferred embodiment is generally from 45 MHz to 26.5 GHz. In order to provide such a constant impedance over this large bandwidth, the R.F. load RO is typically a composite system as depicted in Figure 1. As illustrated, RO has three distinct elements. The first, RO1, is a high frequency distributed load for preventing signals at the reference port from seeing any shunt impedance other than RO. Unlike an isolated lumped resistor which provides virtually no isolation, such a distributed load can be made to provide almost any degree of isolation commensurate with acceptable dimensions. Such isolation requires, however, that there be sufficient loss per unit length to avoid introducing shunt impedance at the frequencies of interest. Losses of 20-25 dB along the length of the load (40-50 dB isolation) are generelly sufficient to avoid bridge imbalance.

The second stage of the reference impedance, RO2, is a lumped load placed at the end of RO1 to provide a termination at lower frequencies where losses in the distributed load, RO1, are insufficient to achieve isolation. To avoid parasitic shunt impedances at these lower frequencies, the third stage, RO3, a ferrite core (balun), is added to keep the shunt reactance high. The magnitude of the impedances of RO2 and RO3 are chosen so that their combined parallel impedance is equal to RO since RO1 is transparent at low frequencies.

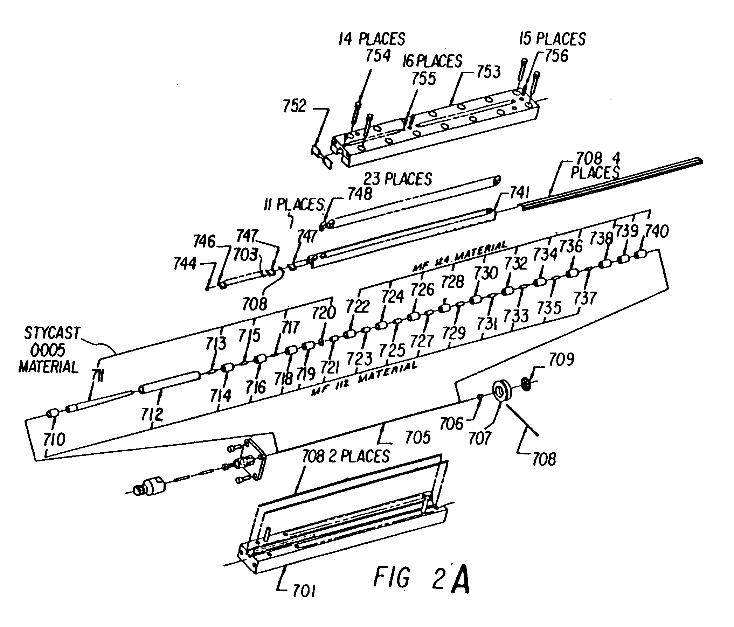

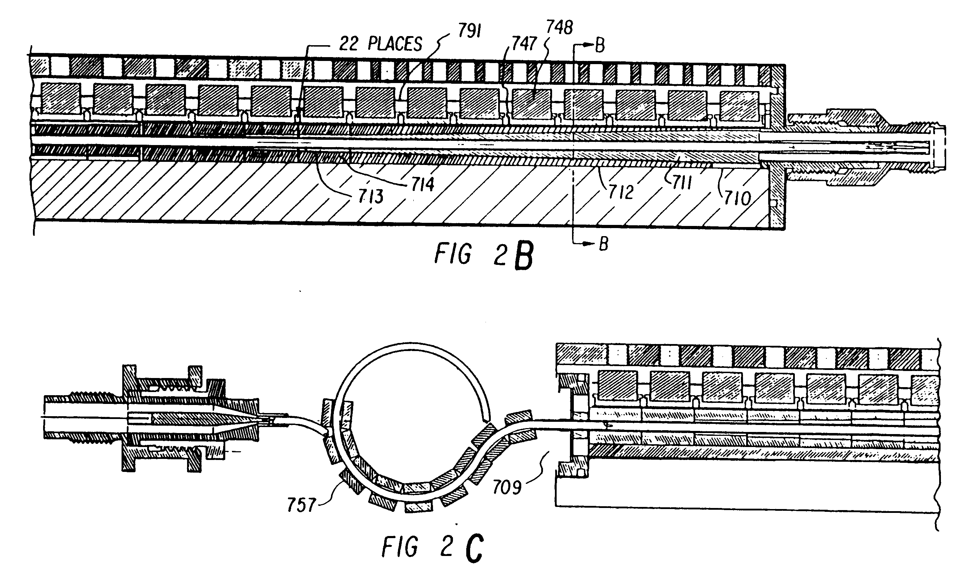

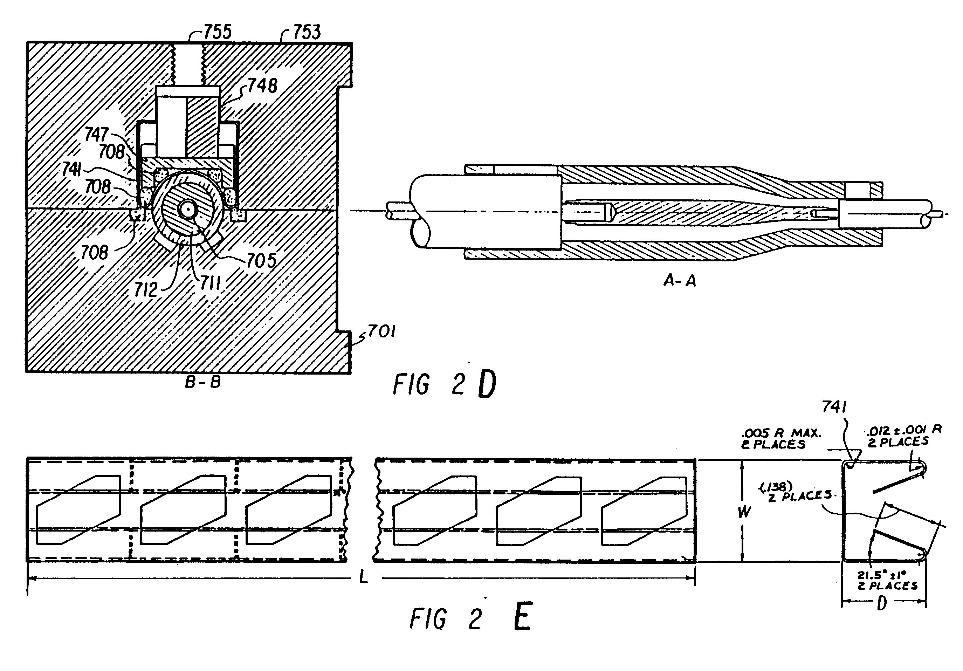

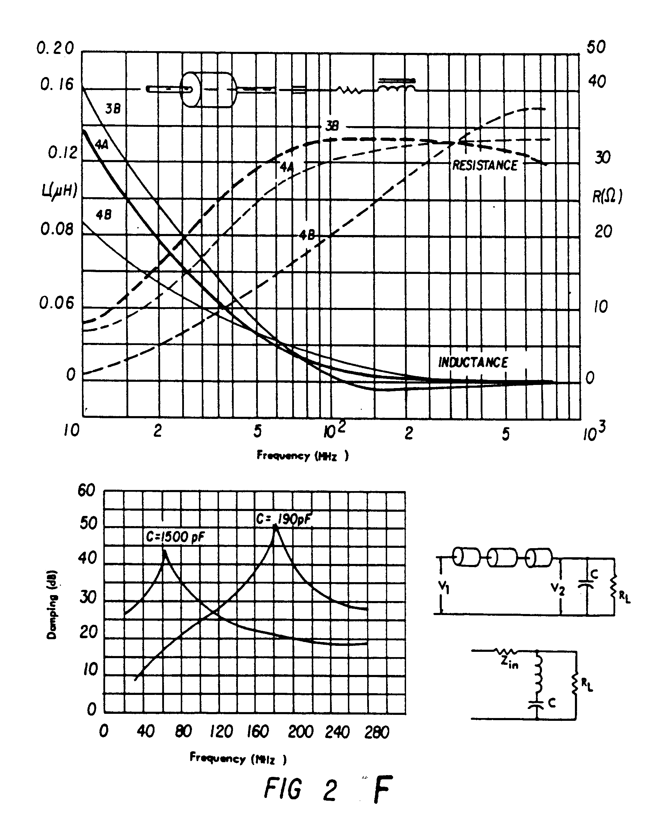

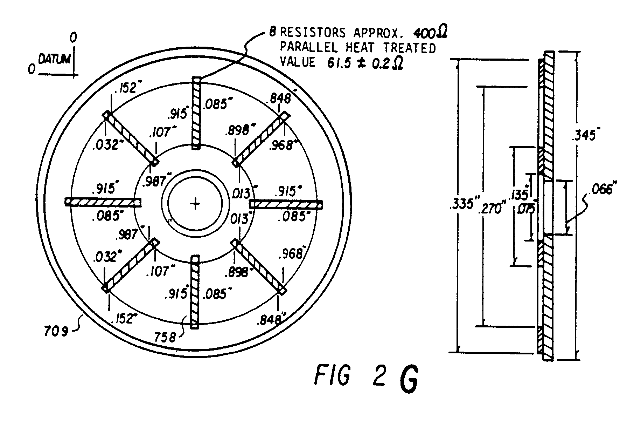

Shown in Figure 2A is an expanded view of distributed load RO1 and lumped load RO2. For purposes of discussion, all elements not already described previously will be numbered in the 700's to associate that element with Figure 2. Element 701 is a bottom ground plane, typically aluminum, having a groove therein to accommodate the distributed load material of the triaxial structure. Tapered loads 711 and 712 typically provide a constant impedance distributed load for frequencies above about 8 GHz, while the balance of the loads 711 and 713 through 740 are for achieving a flat response in the intermediate frequency ranges. As illustrated in Figure 2B, tapered loads 711 and 712 are physically mated to achieve a snug fit. Tapered load 711 is typically constructed of a relatively lossless material such as cross-linked polystyrene having a relative dielectric constant of about 2.54 (e.g., STYCAST 0005, which is manufactured by Emerson & Cuming) so that the distributed load is dielectrically loaded on the front end rather that relying on air as the dielectric. This dielectric loading is very important in achieving the desired matching characteristics with the lumped load. At the front end of tapered load 711 the preferred diameter is about 0.1497 inches (0,3802 cm), while at the distal end the preferred diameter is about 0.0797 inches (0,2024 cm). The preferred length for tapered load 711 is generally about 1.959 inches (4,9759 cm) with taper beginning about 0.230 inches (0,5842 cm) from the front. Tapered load 712 is typically constructed of a machineable lossy material such as MF112 which is also manufactured by Emerson & Cuming. Table I provides a list of the electromagnetic characteristics of MF112 relative to the vacuum as a function of frequency.

The balance of the distributed load, i.e., loads 713 through 740, carries through this tapered load concept, except that the loads are stepwise tapered. Generally, step tapered terminations have a relatively narrow bandwidth and critical dimensionality. However, by using lossy loads in multiple steps (i.e., multiple loads) the bandwidth can be increased while at the same time reducing the overall length of the distributed load section. In addition, the use of lossy loads provides a forgiving structure, since subsequent losses in successive loads tends to obscure reflections at interfaces between loads. As indicated in Figure 2A in the first stepwise taper, inner loads 713, 715, 717, and load spacer 720 are typically constructed of STYCAST 0005 material, while outer loads 714, 716, 718, and 719, and inner loads 721, 723, 725, 727, 729, 731, 733, 735, and 737 are typically constructed of MF112 material. The second stepwise taper begins at load 722 and continues through load 740, with loads 722, 724, 726, 728, 730, 732, 734, 736, 738, 739, and 740 being constructed of MF124, a material produced by Emerson & Cuming which has a substantially higher loss than MF112. Table I also lists the electromagnetic characteristics of MF124 as a function of frequency. MF112 and MF124 were chosen because they are a mixture of lossy elements in a base material which is the same as STYCAST 0005. Hence, at low frequencies where the lossy elements have a minimal loss contribution, the outer taper resembles the inner taper, so that the distributed portion and the lumped load termination together are essentially matched to the reference impedance. Table II is a list of the inside and outside diameters of each of the loads. The linear dimension of each load is 0.25 inches (0,635 cm), except for load 719 which is 0.230 inches (0,5842 cm) long and load 719 which together with load spacer 720 totals 0.25 inches (0,635 cm). As indicated in drawings 2A, 2B, and 2C, the loads are strung in close contact on a center conductor 705. The diameter of center conductor 705 is nominally 0.0474 inches (0,1204 cm).

Holding loads 710 through 740 in place is an adjustable top ground plane 741, typically constructed of gold-plated berylliumcopper and nominally having a width W of 0.237 inches (0,6020 cm), a depth D of 0.197 inches (0,5004 cm), and a length L of 5.735 inches (14,567 cm) (see Figures 2A and 2E). Holes in the top of ground plane 741 permit press blocks 748 to extend through the top surface to contact conductive shoes 747 which in turn contact the lower flanges of the top ground plane, in order to push them into firm contact with the load elements (see Figure 2D for a cross-section showing the deformation of the top ground plane on the outer surface of the load). The force for press blocks 748 is furnished by set screws 755 and 756 mounted in a top housing 753. This ability to tune the individual load elements via the top ground plane is particularly important in achieving a precision load since step tapered loads can be particularly sensitive to small changes in magnetic and dielectric properties. It should also be noted that throughout the system, RFI round strip conductive elastomeric gaskets 708 are provided to insure good electrical contact.

Shown in Figure 2C is the tail end of the reference load illustrating the single loop of the inner coax threaded through a sequence of nine (9) ferrite shielding beads 757. Such beads are used because they have a high magnetic permeability and are very lossy, so that when the inner coax is eventually shorted to ground, there will be enough series loss to isolate the short and provide a precision reference termination. A typical material for beads 757 is Ferroxcube material 3B (available from Hewlett-Packard Company as stock number 9170-0016), having an initial magnetic permeability of 900 relative to the vacuum at 20 degrees Celsius. Beads 757 typically have an inner diameter of 0.051 inches (0,1295 cm), and outer diameter of 0.138 inches (0,3505 cm), and are 0.159 inches (0,4039 cm) long, so as to achieve an impedance of 300 ohms in this balun section. Figure 2F is a plot of the electrical characteristics of beads 757.

Shown in Figure 2G is an expanded view of lumped resistor 709 (the equivalent of RO2 of Figure 1). It is generally constructed by connecting inner and outer rings of gold-coating saphire with eight identical, equally spaced, resistors 758 to obtain a combined resistance of 61.5 ohms.

The outer diameter of the outer ring of the saphire substrate is typically 0.345 inches (0,8763 cm) and the inner diameter is typically 0.270 inches (0,6858 cm).

The outer diameter of the inner ring is typically 0.135 inches (0,3429 cm) and the inner diameter of the inner ring is typically 0.075 inches (0,1905 cm). Resistors 758 are generally constructed of tantalum.

TABLE I

ELECTROMAGNETIC CHARACTERISTICS

| MATERIAL | PROPERTY* | $10^2$ | $10^3$ | $10^4$ | $10^5$ | $10^6$ | $10^7$ | $10^8$ | $10^9$ | $3 \times 10^9$ | $8.6 \times 10^9$ | $10^{10}$ | $1.8 \times 10^{10}$ |
|---|---|---|---|---|---|---|---|---|---|---|---|---|---|
| MF-112 | K' | 20 | 18 | 16 | 14 | 12 | 10 | 8 | 6 | 5.2 | 5.0 | 4.8 | 4.6 |
| | TAN D | 0.02 | 0.02 | 0.03 | 0.03 | 0.03 | 0.04 | 0.04 | 0.04 | 0.05 | 0.05 | 0.04 | 0.03 |
| | K" | 0.04 | 0.36 | 0.48 | 0.42 | 0.36 | 0.40 | 0.32 | 0.24 | 0.26 | 0.25 | 0.19 | 0.14 |
| | M' | 2.0 | 1.9 | 1.8 | 1.7 | 1.6 | 1.5 | 1.5 | 1.4 | 1.4 | 1.1 | 1.1 | 1.0 |
| | TAN M | 0 | 0 | 0 | 0 | 0 | 0 | 0.01 | 0.02 | 0.03 | 0.22 | 0.23 | 0.26 |
| | M" | 0 | 0 | 0 | 0 | 0 | 0 | 0.02 | 0.03 | 0.04 | 0.24 | 0.25 | 0.26 |
| | dB/IN | 0 | 0 | 0 | 0 | 0 | 0 | 0.05 | 0.41 | 1.5 | 12.4 | 14.2 | 25.7 |
| | $\lvert Z \rvert / Z_O$ | 0.32 | 0.32 | 0.34 | 0.35 | 0.37 | 0.39 | 0.43 | 0.48 | 0.52 | 0.47 | 0.48 | 0 47 |
| MF-124 | K' | 260 | 205 | 145 | 95 | 70 | 52 | 40 | 32 | 25.8 | 23.8 | 23.6 | 23.0 |
| | TAN D | 0.04 | 0.39 | 0.36 | 0.31 | 0.26 | 0.20 | 0.14 | 0.08 | 0.07 | 0.05 | 0.03 | 0.04 |
| | K" | 104 | 80 | 52 | 29 | 18 | 10 | 5.6 | 2.6 | 1.8 | 1.19 | 0.71 | 0.92 |
| | M' | 7.0 | 6.9 | 6.8 | 6.7 | 6.6 | 6.3 | 6.0 | 5.0 | 3.8 | 2.50 | 1.5 | 1.0 |
| | TAN M | 0 | 0 | 0 | 0 | 0 | 0 | 0.2 | 0.45 | 0.69 | 1.10 | 1.4 | 2.5 |
| | M" | 0 | 0 | 0 | 0 | 0 | 0 | 1.2 | 2.3 | 2.62 | 2.75 | 2.1 | 2.5 |
| | dB/IN | 0 | 0 | 0 | 0 | 0 | 0.08 | 1.2 | 17 | 50 | 160 | 170 | 378 |
| | $\lvert Z \rvert / Z_O$ | 0.16 | 0.18 | 0.21 | 0.26 | 0.30 | 0.34 | 0.39 | 0.42 | 0.42 | 0.39 | 0.33 | 0.34 |

* Where the complex dielectric constant is given by
(K' − jK" TAN D), the complex magnetic permeability
by (M' − jM" TAN M).

EP 0 327 138 B1

EP 0 327 138 B1

## TABLE II: LOAD ELEMENT DIAMETERS

| ELEMENT NUMBER | O.D. (inches) | (cm) | I.D. (inches) | (cm) |
|---|---|---|---|---|
| 710 | 0.1698 | 0,4313 | 0.1503 | 0,3818 |
| 711 | 0.1497 & 0.0797 | 0,3802 & 0,2024 | 0.0480 | 0,1219 |
| 712 | 0.1698 | 0,4313 | 0.0797 & 0.1497 | 0,2024 & 0,3802 |
| 713 | 0.0800 | 0,2032 | 0.0504 | 0,1280 |
| 714 | 0.1698 | 0,4314 | 0.0800 | 0,2032 |
| 715 | 0.0750 | 0,1905 | 0.0504 | 0,1280 |
| 716 | 0.1698 | 0,4313 | 0.0750 | 0,1905 |
| 717 | 0.0700 | 0,1778 | 0.0512 | 0,1300 |
| 718 | 0.1698 | 0,4313 | 0.0700 | 0,1778 |
| 719 | 0.1698 | 0,4313 | 0.0547 | 0,1389 |
| 720 | 0.1698 | 0,4313 | 0.0478 | 0,1214 |
| 721 | 0.1500 | 0,3810 | 0.0508 | 0,1290 |
| 722 | 0.1698 | 0,4313 | 0.1500 | 0,3810 |
| 723 | 0.1400 | 0,3556 | 0.0504 | 0,1280 |
| 724 | 0.1698 | 0,4313 | 0.1400 | 0,3556 |
| 725 | 0.1300 | 0,3302 | 0.0496 | 0,1260 |
| 726 | 0.1698 | 0,4313 | 0.1300 | 0,3302 |
| 727 | 0.1200 | 0,3048 | 0.0488 | 0,1240 |
| 728 | 0.1698 | 0,4313 | 0.1200 | 0,3048 |
| 729 | 0.1100 | 0,2794 | 0.0484 | 0,1240 |
| 730 | 0.1698 | 0,4313 | 0.1100 | 0,2794 |
| 731 | 0.1000 | 0,2540 | 0.0484 | 0,1240 |
| 732 | 0.1698 | 0,4313 | 0.1000 | 0,2540 |
| 733 | 0.0900 | 0,2286 | 0.0484 | 0,1240 |
| 734 | 0.1698 | 0,4313 | 0.0900 | 0,2286 |
| 735 | 0.0800 | 0,2032 | 0.0484 | 0,1240 |
| 736 | 0.1698 | 0,4313 | 0.0800 | 0,2032 |
| 737 | 0.0700 | 0,1778 | 0.0480 | 0,1240 |
| 738 | 0.1698 | 0,4313 | 0.0700 | 0,1778 |
| 739 | 0.1698 | 0,4313 | 0.0500 | 0,1270 |
| 740 | 0.1698 | 0,4313 | 0.0492 | 0,1250 |

**Claims**

1. Wide bandwidth R.F. load having a substantially constant impedance over a range of frequencies comprising:
   - an input port; and

5

- a first and second conductor coupled to said input port;
characterized by

- a first distributed load (RO1) which is distributed along and between said first (705) and second (701, 741) conductors, said distributed load (RO1) consisting of inner loads (odds 711-737) having an inner taper and of outer loads (evens (712-719, 721-738)) having an outer taper with said inner loads comprising a first material having a first inner dielectric constant and a first inner attenuation coefficient and said outer loads comprising a second material having first outer dielectric constant and a first outer attenuation coefficient, with said first inner dielectric constant being smaller in magnitude than the magnitude of said first outer dielectric constant and said first inner attenuation coefficient being smaller in magnitude than the magnitude of said first outer attenuation coefficient;

- a lumped load (RO2) coupled to said distributed load (RO1) opposite said input port; and

- a second distributed load (RO3) coupled to said lumped load (RO2) opposite said distributed load (RO1) relative to said lumped load, constructed of a lossy material having a magnetic permeability which is substantially larger than the magnetic permeability of both said first material and said second material.

2. R.F. load as claimed in claim 1, characterized in that said first inner dielectric constant is larger than the dielectric constant of air over substantially all of said range of frequencies.

3. R.F. load as claimed in claim 1 or 2, characterized in that a first portion of said inner loads comprises a single continuously tapered loads (711) of said first material and a first portion of said outer load comprises a single continuously tapered load (712) of said second material.

4. R.F. load as claimed in one of claims 1 through 3, characterized in that a second portion of said inner and outer loads comprises a plurality of stepwise tapered loads (713-719, 721-738).

5. R.F. load as claimed in claim 4, characterized in that said inner loads in said second portion comprise said first material.

6. R.F. load as claimed in claim 5, characterized in that said outer loads in said second portion comprise a second material.

7. R.F. load as claimed in one of claims 4 through 6, characterized in that a third portion of said inner and outer loads are stepwise tapered, with said inner loads comprising said second material.

8. R.F. load as claimed in claim 7, characterized in that said outer loads in said third portion comprise a third material.

9. R.F. load as claimed in claim 8, characterized in that the magnitudes of the dielectric constant and attenuation coefficient of said second material are smaller than the dielectric constant and attenuation coefficient of said third material respectively.

10. R.F. load as claimed in one of claims 1 through 9, characterized in that said second conductor (701, 741) is concentric with said first conductor (705) to form a coaxial system about said first conductor (705) with said inner loads being substantially concentrically located within said outer loads, with said outer loads themselves being located within said second conductor.

11. R.F. load as claimed in claim 10 characterized in that said second conductor (701, 741) comprises a plurality of conductors, at least one of which can be adjusted to provide independent ground plane proximity to each load element for tuning said first distributed load.

12. R.F. load as claimed in one of claims 6 through 11 characterized in that said second conductor (701, 741) is concentric with said first conductor (705) to form a coaxial system about said first conductor (10) with said first distributed load (RO1) located therein.

13. R.F. load as claimed in one of claims 6 through 12 characterized in that said first conductor (705) is itself an outer conductive sheath for a second coaxial line (Fig. 2D).

**Patentansprüche**

1. Breitbandige H.F.-Last, die über ein Frequenzband eine im wesentlichen konstante Impedanz hat und aufweist:
   - einen Eingangskanal; und
   - einen ersten und zweiten mit dem Eingangskanal verbundenen Leiter;
     gekennzeichnet durch
   - eine erste verteilte Last (RO1), die entlang und zwischen dem ersten (705) und dem zweiten Leiter (701, 741) verteilt ist und die aus inneren Lasten (Ungeraden (711-737)) mit einem inneren Konus und äußeren Lasten (Geraden (712-719, 721-738)) mit einem äußeren Konus besteht, wobei die inneren Lasten einen ersten Werkstoff mit einer ersten inneren Dielektrizitätskonstanten und einem ersten inneren Dämpfungskoeffizienten und die äußeren Lasten aus einem zweiten Werkstoff mit einer ersten äußeren Dielektrizitätskonstanten und einem ersten äußeren Dämpfungskoeffizienten bestehen, von denen der Betrag der ersten inneren Dielektrizitätskonstanten kleiner ist als der Betrag der ersten äußeren Dielektrizitätskonstanten und der Betrag des ersten inneren Dämpfungskoeffizienten kleiner ist als der Betrag des ersten äußeren Dämpfungskoeffizienten;
   - eine konzentrierte Last (RO2), die dem Eingangskanal gegenüberliegend mit der verteilten Last (RO1) gekoppelt ist; und
   - eine zweite verteilte Last (RO3), die der verteilten Last (RO1) in Bezug auf die konzentrierte Last gegenüberliegt, mit der konzentrierten Last (RO2) verbunden ist und aus einem dämpfenden Werkstoff gebildet ist, dessen magnetische Permeabilität wesentlich größer ist als die magnetische Permeabilität sowohl des ersten als auch des zweiten Werkstoffs.

2. H.F.-Last nach Anspruch 1, dadurch gekennzeichnet, daß im wesentlichen im gesamten Frequenzband die erste innere Dielektrizitätskonstante größer als die Dielektrizitätskonstante der Luft.

3. H.F.-Last nach Anspruch 1 oder 2, dadurch gekennzeichnet, daß ein erster Abschnitt der inneren Lasten eine einzelne Last (711), die kontinuierlich konisch verläuft aus dem ersten Werkstoff und ein erster Abschnitt der äußeren Last eine einzelne Last (712), die kontinuierlich konisch verläuft, aus dem zweiten Werkstoff aufweisen.

4. H.F.-Last nach einem der Ansprüche 1 bis 3, dadurch gekennzeichnet, daß ein zweiter Abschnitt der inneren und äußeren Lasten mehrere sich schrittweise konisch verjüngende Lasten (713-719, 721-738) aufweist.

5. H.F.-Last nach Anspruch 4, dadurch gekennzeichnet, daß die inneren Lasten im zweiten Abschnitt den ersten Werkstoff enthalten.

6. H.F.-Last nach Anspruch 5, dadurch gekennzeichnet, daß die äußeren Lasten im zweiten Abschnitt einen zweiten Werkstoff enthalten.

7. H.F.-Last nach einem der Ansprüche 4 bis 6, dadurch gekennzeichnet, daß ein dritter Abschnitt der inneren und äußeren Lasten stufenweise konisch verjüngt ist, wobei die inneren Lasten den zweiten Werkstoff enthalten.

8. H.F.-Last nach Anspruch 7, dadurch gekennzeichnet, daß die äußeren Lasten im dritten Abschnitt einen dritten Werkstoff enthalten.

9. H.F.-Last nach Anspruch 8, dadurch gekennzeichnet, daß die Beträge der Dielektrizitätskonstanten und des Dämpfungskoeffizienten des zweiten Werkstoffs jeweils geringer sind als die Dielektrizitätskonstante und der Dämpfungskoeffizient des dritten Werkstoffs.

10. H.F.-Last nach einem der Ansprüche 1 bis 9, dadurch gekennzeichnet, daß der zweite Leiter (701, 741) konzentrisch zum ersten Leiter (705) verläuft um ein koaxiales System um den ersten Leiter (705) zu bilden, wobei die inneren Lasten im wesentlichen konzentrisch innerhalb der äußeren Lasten liegen und die äußeren Lasten sich ihrerseits innerhalb des zweiten Leiters befinden.

**11.** H.F.-Last nach Anspruch 10, dadurch gekennzeichnet, daß der zweite Leiter (701, 741) eine Vielzahl von Leitern enthält, von denen wenigstens einer einstellbar ist, um eine unabhängige Erdebene in der Nähe jedes Lastelements zur Abstimmung der verteilten Last zu ermöglichen.

**12.** H.F.-Last nach einem der Ansprüche 6 bis 11, dadurch gekennzeichnet, daß der zweite Leiter (701, 741) konzentrisch zum ersten Leiter (705) liegt, um ein koaxiales System um den ersten Leiter (705) zu bilden, wobei die erste verteilte Last (RO1) innerhalb liegt.

**13.** H.F.-Last nach einem der Ansprüche 6 bis 12, dadurch gekennzeichnet, daß der erste Leiter (705) selbst ein äußerer leitender Mantel für eine zweite Koaxialleitung ist (Fig. 2d).

**Revendications**

**1.** Charge pour fréquence radio, à largeur de bande étendue, qui présente une impédance sensiblement constante sur une gamme de fréquences, comportant :
   - une entrée, et
   - des premier et second conducteurs couplés à l'entrée,
   caractérisée par :
   - une première charge distribuée (RO1) qui est distribuée le long et entre les premier (705) et second (701, 741) conducteurs, la charge distribuée (RO1) consistant en des charges internes (nombres impairs de 711 à 737) qui ont un cône interne et des charges externes (nombres pairs de 712 à 719, de 721 à 738) qui ont un cône externe, les charges internes comprenant une première matière ayant une première constante diélectrique interne et un premier coefficient d'atténuation interne et les charges externes comprenant une deuxième matière ayant une première constante diélectrique externe et un premier coefficient d'atténuation externe, la première constante diélectrique interne étant inférieure en valeur à la valeur de la première constante diélectrique externe et le premier coefficient d'atténuation interne étant inférieur en valeur à la valeur du premier coefficient d'atténuation externe,
   - a l'opposé de l'entrée susdite, une charge concentrée (RO2) couplée à ladite charge distribuée (RO1),
   - une seconde charge distribuée (RO3) couplée à la charge concentrée (RO2), à l'opposé de la charge distribuée (RO1) susdite par rapport à la charge concentrée, fabriquée en une matière dissipative qui a une perméabilité magnétique sensiblement supérieure à la perméabilité magnétique tant de ladite première matière que de la deuxième matière susdites.

**2.** Charge pour fréquence radio suivant la revendication 1, caractérisée en ce que ladite première constante diélectrique interne est supérieure à la constante diélectrique de l'air, sur sensiblement toute la gamme de fréquences.

**3.** Charge pour fréquence radio suivant la revendication 1 ou 2, caractérisée en ce qu'une première partie des charges internes comporte une unique charge continûment conique (711) de la première matière susdite et en ce qu'une première partie de la charge externe comporte une charge unique continûment conique (712) de la seconde matière susdite.

**4.** Charge pour fréquence radio suivant l'une quelconque des revendications 1 à 3, caractérisée en ce qu'une seconde partie desdites charges internes et externes comprend une pluralité de charges coniques en gradin (713 à 719, 721 à 738).

**5.** Charge pour fréquence radio suivant la revendication 4, caractérisée en ce que lesdites charges internes de la seconde partie contiennent ladite première matière.

**6.** Charge pour fréquence radio suivant la revendication 5, caractérisée en ce que les charges externes de la seconde partie susdite contiennent une deuxième matière.

**7.** Charge pour fréquence radio suivant l'une quelconque des revendications 4 à 6, caractérisée en ce qu'une troisième partie des charges internes et une des externes sont coniques en gradin, les charges internes susdites contenant ladite deuxième matière.

8. Charge pour fréquence radio suivant la revendication 7, caractérisée en ce que les charges externes susdites de la troisième partie contiennent une troisième matière.

9. Charge pour fréquence radio suivant la revendication 8, caractérisée en ce que les valeurs de la constante diélectrique et du coefficient d'atténuation de la deuxième matière sont inférieures à celles de la constante diélectrique et du coefficient d'atténuation respectifs de la troisième matière.

10. Charge pour fréquence radio suivant l'une quelconque des revendications 1 à 9, caractérisée en ce que le second conducteur susdit (701, 741) est concentrique audit premier conducteur (705) afin de former un système coaxial autour du premier conducteur (705), les charges internes étant situées sensiblement concentriquement à l'intérieur des charges externes, les charges externes elles-mêmes étant situées à l'intérieur du second conducteur.

11. Charge pour fréquence radio suivant la revendication 10, caractérisée en ce que le second conducteur (701, 741) comporte une pluralité de conducteurs dont au moins un peut être réglé pour procurer un plan de base indépendant à proximité de chaque élément de charge afin d'accorder ladite première charge distribuée.

12. Charge pour fréquence radio suivant l'une quelconque des revendications 6 à 11, caractérisée en ce que le second conducteur (701, 741) est concentrique au premier conducteur (705) pour former un système coaxial autour du premier conducteur (705), ladite première charge distribuée (RO1) étant située à l'intérieur de celui-ci.

13. Charge pour fréquence radio suivant l'une quelconque des revendications 6 à 12, caractérisée en ce que le premier conducteur (705) est lui-même une enveloppe conductrice externe pour une seconde ligne coaxiale (figure 2D).

FIG 1

FIG 2A

EP 0 327 138 B1

22 PLACES

791  748

747  —B

FIG 2 B

714

713  712  711  710

B

709

757

FIG 2 C

755   753

748

747
708
741
708

708

708   705

712   711

B-B

701

FIG 2 D

A-A

.005 R MAX.
2 PLACES

741

.012 ±.001 R
2 PLACES

(.138)
2 PLACES

W

21.5° ±1°
2 PLACES

L

D

FIG 2 E

EP 0 327 138 B1

13

FIG 2 F

FIG 2 G